# EUROPEAN PATENT APPLICATION

(11) **EP 4 826 978 A1**
(43) Date of publication of application: **21.10.2026**
(21) Application number: 25171359.0
(22) Date of filing: 17.04.2025
(51) Int. Cl.: H02M 3/158, H02M 1/00, H02M 1/08, H02M 3/07, H02M 1/32, H03K 17/687

(54) **VOLTAGE TRANSMITTER CIRCUIT**

(71) Applicant: EM Microelectronic-Marin SA, 2074 Marin-Epagnier (CH)
(72) Inventor: NERAD, Jiri, 15800 Praha (CZ)
(74) Representative: ICB SA

(57) **Abstract**

In one aspect the present invention concerns a voltage transmitter circuit (10) comprising:
- a supply voltage terminal (VSPL),
- an output voltage terminal (VOUT) connectable to a capacitive load (CLOAD),
- a first voltage limiter (L01) comprising a high-voltage terminal (VHIGH) and a low voltage terminal (VLOW), wherein the low voltage terminal (VLOW) is connected to ground,
- a second voltage limiter (L12) in series to the first voltage limiter (L01) and connected to the supply voltage terminal (VSPL),
- a first switch stage (S01) connected in parallel to the first voltage limiter (L01), and comprising a first output terminal (VOUT01) connected to the output voltage terminal (VOUT),
- a second switch stage (S12) connected in parallel to the second voltage limiter (L12), and comprising a second output terminal (VOUT12) connected to the output voltage terminal (VOUT), and
- a first tank capacitor (C1) connected to the high-voltage terminal (VHIGH) of the first voltage limiter (L01).

## Description

### Field of the invention

The present invention relates to the field of voltage transmitter circuits, and specifically, to electrostatic communication that is based on transmitting and receiving square wave patterns in a voltage type signal carried over a capacitively coupled channel. A main application may be the communication between a pointing or drawing device, such as a stylus or electronic pen, and the related display device, such as a tablet or computer screen.

Other applications may include any other electronic circuits designed to repeat the process of charging a load capacitance or capacitor from a constant voltage supply and then discharging said capacitance or capacitor to ground where the power or energy efficiency of the complete process of charging and discharging is important.

### Background

Switching power supply topologies are known in the art, e.g. in document US 7 394 673 B2. Generally, such power supply topologies imply a basic form or various modifications of a charge pump circuit that uses a flying capacitor.

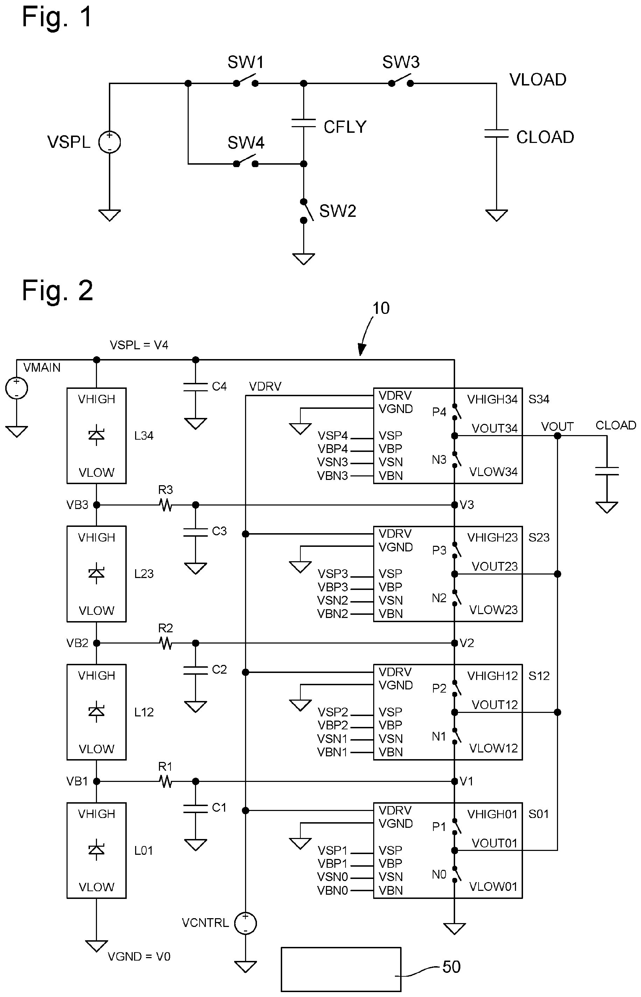

Fig. 1 shows an example of a basic configuration where, in the first half of a clock cycle, a flying pump capacitor CFLY is connected in parallel with a constant voltage supply VSPL, and, in the second half of the clock cycle, the pump capacitor CFLY is placed in series with said voltage supply VSPL, and, at the same time, the resulting series combination of CFLY and VSPL is connected in parallel with the load capacitance CLOAD.

The charge pump requires a set of switches SW1, SW2, SW3, SW4, wherein, during the first half of the cycle, switches SW1 and SW2 are closed or conductive while switches SW3 and SW4 are open or nonconductive, and, during the second half of the cycle, switches SW1 and SW2 are open or nonconductive while switches SW3 and SW4 are closed or conductive. A non-overlap timing of the operation of the switch pairs is important, that is, the switch configuration can only be changed in such a way that both of the two switches that are presently closed or conductive are first open or made nonconductive, and only then the other two switches are closed or made conductive.

This method can be used either to charge the load capacitance from the supply when the load voltage VLOAD across the load capacitance CLOAD is smaller than twice the supply voltage VSPL, or to discharge the load capacitance CLOAD into the supply VSPL when the load voltage VLOAD across the load capacitance CLOAD is greater than twice the supply voltage VSPL. In the former case, charge as well as energy is transferred from the supply voltage VSPL into the load capacitance CLOAD whereas, in the latter case, charge as well as energy is transferred from the load capacitance CLOAD back into the voltage supply VSPL.

In conclusion, the general principle of charge pump allows a two-way transfer of both charge and energy between a voltage supply and a load capacitor or capacitance.

Various modifications or extensions to the described technique exist, where the flying pump capacitance CFLY can be either smaller or larger than the load capacitance CLOAD, the number of cycles required to transfer the specified amount of charge or energy can be large or small, and more complex switch configurations involving multiple pump capacitors can be used. However, systems known in the art require the use of flying pump capacitors where no terminal or plate of said capacitor can be permanently connected to the ground or other static voltage and both terminals or plates are switched. Consequently, due to the principle of capacitance, similar voltage waveforms and comparable voltage swings are present at both terminals or plates.

The key problem emerges when the switched flying capacitors need to be used to generate relatively large voltage swings, typically those exceeding 50V. The presence of large voltages excludes the use of capacitor structures with thin dielectric layers, leaving only those types where metal layers and via shapes form the plates while the inter metal silicon dioxide forms the relatively thick dielectric, such as the fringe or sandwich capacitor types. However, these capacitors have poor ratio between the useful capacitance between the plates and the parasitic capacitance between at least one plate and ground. If such capacitor type is used to implement a flying capacitor described above, then one or more relatively large parasitic capacitances are present at nets with large voltage swings. Consequently, periodic charging and discharging of relatively large grounded capacitances cannot be avoided, typically meaning significant power losses and major degradation to the power efficiency of the whole process. The use of more complex charge pump structures cannot resolve this problem as long as flying capacitors are required.

It is therefore desirable to provide an improvement to the voltage transmitter circuit, that involves charge transfer between a driver circuit and the capacitive load but completely avoids the use of flying pump capacitors.

### Summary of the invention

In one aspect there is provided a voltage transmitter circuit, e.g., for charging and discharging a capacitive load. The voltage transmitter circuit comprises a supply voltage terminal. The supply voltage terminal is connected or is connectable to a supply voltage, e.g., to a DC voltage source, e.g., in form of a battery. The voltage transmitter circuit further comprises an output voltage terminal, which is connected or which is connectable to a capacitive load.

The voltage transmitter circuit further comprises a first voltage limiter. The first voltage limiter comprises a high-voltage terminal and a low voltage terminal. In some examples, the low voltage terminal is connected or is connectable to ground. The voltage transmitter circuit further comprises a second voltage limiter. The second voltage limiter is connected in series to the first voltage limiter. The second voltage limiter is connected or is connectable to the supply voltage terminal.

The voltage transmitter circuit further comprises a first switch stage, which is connected in parallel to the first voltage limiter. The first switch stage comprises a first output terminal connected to the output voltage terminal. The voltage transmitter circuit further comprises a second switch stage, which is connected in parallel to the second voltage limiter. The second switch stage comprises a second output terminal, which is connected to the output voltage terminal.

Moreover, the voltage transmitter circuit comprises at least a first tank capacitor, which is connected to the high-voltage terminal of the first voltage limiter and the low-voltage terminal of the second voltage limiter. The first tank capacitor may be further connected to the first switch stage and to the second switch stage. This way and depending on the switching configuration of one of the first and the second switch stages, the first tank capacitor can be selectively connected or coupled to the capacitive load at the output voltage terminal.

According to some examples, the first and second voltage limiters are connected in series between the supply voltage terminal and ground. They may be configured to provide a uniform voltage spacing therebetween, i.e., the voltage difference across the first and second voltage limiters is designed to be approximately equal.

The intermediate voltage level maintained by the first tank capacitor may be directly connected to the first switch stage and to the second switch stage. These connections are designed to carry a dominant transient current or charge transfer during the operation of the voltage transmitter circuit.

Specifically, and as the capacitive load is charged or discharged, the related charge or discharge current flows via the capacitive load, one of the first and the second switch stages and the at least first tank capacitor.

In addition, the voltage transmitter circuit comprises a kind of a bias network, that is primarily designed to define the operating voltages at the first tank capacitor but is not supposed to carry significant currents. The bias network includes the first and second voltage limiters and optionally a bias resistor coupled to the tank capacitor. The voltage limiters are stacked, that is, they form a series or string from the supply voltage terminal via intermediate voltage levels to ground. The static current along this path is designed to be much smaller than the charge or discharge currents flowing between the capacitive load and the tank capacitors or the full supply voltage terminal or the ground terminal during the operation of the circuit.

In some examples, the optional bias resistor is designed to have large resistance and is placed between the series or string combination of the voltage limiters on one hand and the tank capacitor on the other. In effect, said resistor limits the current flowing between the series or string combination of voltage limiters and the tank capacitor to a very small value that is much smaller than the charge or discharge currents flowing between the capacitive load and the tank capacitors or the full supply voltage terminal or the ground terminal during the operation of the circuit.

According to a further example the first tank capacitor comprises a first terminal and a second terminal, wherein the first terminal of the first tank capacitor is connected to the high-voltage terminal of the first voltage limiter and the low voltage terminal of the second voltage limiter and wherein the second terminal of the first tank capacitor is connected to ground. In some examples the tank capacitor is permanently connected to ground and the voltage swing on the first terminal of the tank capacitor is designed to be as small as possible. In some examples, the voltage transmitter circuit comprises only grounded tank capacitors supposed to operate in a static way, wherein one terminal of the respective tank capacitor is permanently connected to ground and the voltage swing on the other terminal is designed to be as small as possible. In this way, there is provided a novel architecture which uses a two-way charge transfer between the supply voltage terminal and the capacitive load but completely avoids the use of flying pump capacitors.

In effect, the at least first tank capacitor acts and behaves as a pump capacitor and serves to transiently exchange a charge with the capacitive load.

According to a further example, the first switch stage comprises a first high-voltage terminal and a first low-voltage terminal. The first low-voltage terminal is connected to ground. The first high-voltage terminal may be connected to the first terminal of the first tank capacitor.

According to a further example the second switch stage comprises a second high-voltage terminal and a second low-voltage terminal. The second low-voltage terminal is connected to the first high-voltage terminal of the first switch stage. Accordingly, the first and the second switch stages may be connected in series. Both, the first switch stage and the second switch stage may be connected with their respective output voltage terminals, i.e., with their first output terminal and with their second output terminal to the load capacitance.

Since the first and the second switch stages are connected in parallel with first and second voltage limiters, respectively, the second low-voltage terminal of the second switch stage is connected to the respective low-voltage terminal of the second voltage limiter and to the first high-voltage terminal of the first voltage limiter. In this way the tank capacitor can be selectively connected or coupled to the capacitive load, either via the first switch stage or via the second switch stage.

Specifically, for transferring a charge from the tank capacitor to the load capacitor, e.g., to charge the capacitive load, the first tank capacitor is connectable to the capacitive load via the first switch stage. For discharging the capacitive load and for charging the first tank capacitor correspondingly, the capacitive load is connectable to the first tank capacitor via the second switch stage. In this way, energy stored in the capacitive load is not dissipated but is used to recharge the first tank capacitor when the signal at the capacitive load ramps down.

Vice versa, when the signal at the output voltage terminal has to ramp up, a charge previously stored in the at least first tank capacitor can be used to transfer a respective charge to the capacitive load thereby increasing the voltage signal at the output voltage terminal. In effect, the charging and discharging process during a signal period may use only switches and grounded capacitive elements, that is, a transient current flows via the at least first tank capacitor with virtually no share or contribution from the optional bias resistors or other parts of the bias network.

According to a further example the first switch stage and the second switch state each comprise a switch of a first type and a switch of a second type. The switch of the first type is operable to connect the high-voltage terminal of the first or second switch stages with the respective output terminals of the first or second switch stages, respectively. The switch of the second type is operable to connect the low-voltage terminal of the first switch stage or of the second switch stage with the respective output terminal of the first or second switch stages.

In detail, the switch of the first type of the first switch stage is operable to connect the first high-voltage terminal of the first switch stage with the first output terminal of the first switch stage. The switch of second type of the first switch stage is operable to connect the first output terminal of the first switch stage to ground. The switch of the first type of the second switch stage is operable to connect the second high-voltage terminal of the second switch stage to the output voltage terminal. The switch of the second type of the second switch stages is operable to connect the second low-voltage terminal of the second switch stage to the output voltage terminal.

Switching of the first and the second switch stages, e. g., switching of respective first and second type switches of the first and the second switch stages, may be conducted in a nonoverlapping and sequential manner.

In this way, an uncontrolled charging or discharging of the capacitive load can be avoided. In effect, the switch stages, e.g., with their switches of first and second type, may be operated in such a way that at any given time, only one switch is closed or is conductive while all other switches are open or nonconductive. The switch configuration may be changed in a nonoverlapping way, that is, the closed conductive switch is first opened or made nonconductive before any other switch is closed or made conductive.

In this way, uncontrolled dissipation of energy can be effectively avoided and the voltage transmitter circuit can be operated in a rather energy efficient way.

According to a further example, one of the first high-voltage terminal and the second low-voltage terminal is connected to the first tank capacitor. In some examples, both, the first high-voltage terminal and the low-voltage terminal are connected to the tank capacitor. This might be due to the fact that the first high-voltage terminal and the second low-voltage terminal may be permanently connected. They may be arranged in parallel to the first tank capacitor.

According to a further example the voltage transmitter circuit further comprises a third voltage limiter, which is connected in series to the second voltage limiter. The voltage transmitter circuit further comprises a third switch stage connected in parallel to the third voltage limiter and comprising a third output terminal connected to the output voltage terminal. The voltage transmitter circuit may further comprise a second tank capacitor, which is connected to a high-voltage terminal of the second voltage limiter. Typically, the third voltage limiter comprises a third low-voltage terminal, which is connected to the second high-voltage terminal of the second voltage limiter. Also, the third switch stage comprises a third low-voltage terminal and a third high-voltage terminal. Here, the third low-voltage terminal may be connected to the second high-voltage terminal of the second switch stage. Accordingly, it may be also connected to the second tank capacitor.

The second tank capacitor may comprise a first terminal, which is connected to both the high-voltage terminal of the second voltage limiter and to the low-voltage terminal of the third voltage limiter. It may be also connected to the second high-voltage terminal of the second switch stage and to the third low-voltage terminal of the third switch stage.

Typically, the third voltage limiter is connected in series between the second voltage limiter and the supply voltage terminal. In effect, the configuration of the third switch stage, the third voltage limiter and the second tank capacitor is equivalent or substantially identical to the configuration of the second voltage limiter, the second switch stage and the first tank capacitor.

According to further examples, the voltage transmitter circuit may be further expanded by a fourth voltage limiter in series to the third voltage limiter, by a fourth switch stage connected in parallel to the fourth voltage limiter and by a third tank capacitor connected to a high-voltage terminal of the third voltage limiter. Also here, the implementation and operation of the fourth voltage limiter, the fourth switch stage and the third tank capacitor may be substantially identical or equivalent to the third voltage limiter, the third switch stage and the second tank capacitor, respectively.

The voltage transmitter circuit may be further expanded up to a number N of voltage limiters, an equal number N of switch stages and a respective number of N-1 tank capacitors.

The transmitter circuit may be designed to maximize the amount of charge that is conserved or exchanged between the capacitive load on the one hand and the tank capacitors on the other hand. Charge is only lost when the output voltage terminal is connected via the first switch stage to the ground voltage. Recharge from the supply voltage is only needed when the output voltage terminal is connected via the Nth switch stage to the full supply voltage. In contrast to a classic inverter, which charges the load capacitance to the full supply and then completely discharges the load capacitance to ground, the present topology requires N times less charge, where N equals the number of stacked voltage limiters and stacked switch stages. The same factor of improvement applies to power or energy consumed by the voltage transmitter circuit.

According to a further example the third switch stage comprises a third high-voltage terminal and a third low-voltage terminal. The third low-voltage terminal is connected to the second high-voltage terminal of the second switch stage. At least one of the second high-voltage terminal and the third low-voltage terminal is connected to the second tank capacitor. In some examples, both, the second high-voltage terminal and the third low-voltage terminal are connected to the second tank capacitor, i.e., to the first terminal of the second tank capacitor, whereas a second terminal of the second tank capacitor is connected to ground.

According to a further example the second tank capacitor comprises a first terminal connected to the second high-voltage terminal and further comprises a second terminal, which is connected to ground.

According to a further example the second tank capacitor comprises a first terminal connected to the second high-voltage terminal and a second terminal connected to at least one of the first high-voltage terminal and the second low-voltage terminal. Here, the second tank capacitor may be provided in addition to the first tank capacitor. In some examples, the first tank capacitor may be connected parallel to the second switch stage and to the second voltage limiter. Likewise, a second tank capacitor may be arranged or connected in parallel to the third switch stage and to the third voltage limiter. Such a solution may bring the advantage of reduced voltage across each of these capacitors, allowing the use of capacitor types with thin dielectrics and greater area efficiency.

According to a further example the voltage transmitter circuit comprises a digital controller, which is operable to control switching operations of the first and the second switch stages and optionally, also switching of the optional third and fourth switch stages, e.g., in a non-overlapping sequential order.

In this way, and according to the digital logic and programming, desired rising and falling voltage signals can be provided at the capacitive load.

According to another example the switch of the first type of the first and/or second switch stages comprises a LD PMOS transistor connected to the high-voltage terminal and connected to the output terminal of the first and/or second switch stages. A LD PMOS transistor, i.e., a laterally-diffused metal oxide semiconductor transistor is operable to manage comparatively high voltage differences between the source terminal and the drain terminal.

According to a further example, the switch of the second type of the first and/or a second switch stages comprises a LD NMOS transistor connected to the low-voltage terminal and connected to the output terminal of the first and/or of the second switch stages, respectively. A LD NMOS transistors likewise is capable to handle comparatively large voltage differences between the source terminal and the drain terminal.

Use of LD transistors of PMOS type and NMOS type is of particular benefit to handle situations, wherein there is provided comparatively large positive voltage at a drain compared to the voltage at the source; and vice versa.

While the LD NMOS transistors can handle large positive voltages at its drain with respect to the voltage at its source, the LD PMOS devices can handle large negative voltages at its drain with respect to the voltage at its source.

According to a further example the switch stages include one or more protection diodes at the low-voltage terminal as well as at the high-voltage terminal that serve to protect the LD MOS transistors.

With the examples of the first switch stage and the Nth switch stage there may be provided at least a first protection diode between the drain of the switch of the first type of the first switch stage and the first output terminal. There may be likewise provided a protection diode between the drain of the switch of the second type of the Nth switch stage and the Nth output terminal.

In this way, and with an LD NMOS device there can be covered situations where the voltage at the Nth output terminal is below the voltage at the Nth low-voltage terminal. Likewise, and with the LD PMOS device there can be handled and covered situations where the voltage at the first output terminal is above the voltage at the first high-voltage terminal.

With the first switch stage, where the first low-voltage terminal may be connected to ground, such protection diodes may be omitted for the LD NMOS transistor. With the Nth switch stage, where the high-voltage terminal of the respective switch stage is connected to the full supply voltage the protection diode may be omitted for the LD PMOS device because the respective output voltage can never get above the supply voltage.

The protection diodes may be implemented as Schottky type of diodes that have a small forward voltage and virtually no minority carrier injection. In some examples, other implementations of diode devices may be also suitable if forward current via the diode is acceptable in the given technology.

According to another example the voltage transmitter circuit, specifically, the switch stages of the voltage transmitter circuit comprise at least one blocking switch of a first type and a blocking switch of a second type. The blocking switch of the first type is coupled to the LD PMOS transistor. The blocking switch of the second type is coupled to the LD NMOS transistor. The blocking switch of the first type is operable to connect a gate of the LD PMOS transistor to the high-voltage terminal and the blocking switch of the second type is operable to connect a gate of the LD NMOS transistor to the low voltage terminal of the respective switch stages.

This way it can be ensured that the LD NMOS transistors can remain fully open or nonconductive and remain in such a condition even when the output voltage makes a fast rising transition. Accordingly, the blocking switch of the second type, e.g. a LD NMOS blocking switch can be used that shorts the gate terminal of the LD NMOS transistor to the respective low-voltage terminal and thus guarantees a zero value of its gate source voltage.

Likewise and in order to ensure that the LD PMOS transistor can be made fully open or nonconductive and remain in such condition even when the output voltage makes a fast falling transition, the blocking switch of the first type, e.g., implemented as a LD PMOS switch, can be used that shorts the gate terminal of the LD PMOS transistor to the high-voltage terminal and thus guarantees a zero value of its gate source voltage.

According to a further example the respective blocking switch can be protected by a Zener diode and controlled with a standard buffer or driver coupled by a coupling capacitor. In contrast to the switches of the first or second type the respective blocking switches do not have any terminal exposed to a large voltage transition and the capacitive coupling via a capacitor is sufficient to provide an appropriate control voltage waveform at the gate of the respective blocking switch devices.

According to a further aspect, the present invention further relates to an electronic device comprising a battery and a voltage transmitter circuit as described above. Here, the supply voltage terminal of the voltage transmitter circuit is connectable or is connected to the battery and the voltage of the battery is converted into a predetermined voltage at the output voltage terminal of the voltage transmitter circuit. Insofar, all features, effects and benefits as described above in connection with the voltage transmitter circuit equally apply to the electronic device; and vice versa. According to some examples, the electronic device is a portable electronic device. It may be implemented as a battery powered electronic device.

In some examples, the electronic device comprises a pointing or drawing device, such as an electronic stylus or electronic pen.

In still another aspect the present disclosure further relates to a method of converting a supply voltage provided at the supply voltage terminal of a voltage transmitter circuit as described above into an output voltage at the output voltage terminal of such a voltage transmitter circuit. The method comprises the steps of sequentially operating first and second switch stages of the voltage transmitter circuit, thereby charging and/or discharging the capacitive load and providing a predetermined voltage at the output voltage terminal. In effect, and since the method of converting a supply voltage into the output voltage of output voltage signal is to be conducted by a voltage transmitter circuit as described above, all features, effects and benefits as described above in connection with the voltage transmitter circuit equally apply to the method of converting the supply voltage and vice versa.

It is further to be noted that the voltage transmitter circuit as described herein relates to the type or class of electronic circuits that do not include or require inductors, thus allowing a full integration in a silicon chip or a solid state circuit.

### Brief description of the drawings

In the following, numerous examples of the invention will be described in greater detail by making reference to the drawings, in which:
- Fig. 1 schematically illustrates a prior art solution of a charge pump circuit,
- Fig. 2 is a block diagram of an example of the present voltage transmitter circuit,
- Fig. 3 is a diagram illustrating numerous transient voltage levels of the voltage transmitter circuit
- Fig. 4 is a schematic diagram of the details of the switch stages,
- Fig. 5 shows a timing diagram of generating a rising transition at the system output,
- Fig. 6 shows a respective timing diagram of generating a falling transition at the system output,
- Fig. 7 is a schematic diagram showing details of the voltage limiter,
- Fig. 8 is a block diagram of an example of a voltage regulation loop implemented with the voltage transmitter circuit, and
- Fig. 9 shows an alternative example of the voltage transmitter circuit.
- Fig. 10 shows an example of an electronic device comprising the voltage transmitter circuit.

### Detailed description of the invention

Fig. 2 shows a block diagram of an example of the voltage transmitter circuit 10 comprising at least a supply voltage terminal VSPL, an output voltage terminal VOUT, a first voltage limiter L01, a second voltage limiter L12, a first switch stage S01, a second switch stage S12 and a first tank capacitor C1. The first voltage limiter comprises a high-voltage terminal VHIGH and low voltage terminal VLOW. The low voltage terminal VLOW of the first voltage limiter L01 is connected to ground. The second voltage limiter L12 is connected in series to the first voltage limiter L01 and is further connected to the supply voltage terminal VSPL. With the present example, there are provided further voltage limiters, namely a third voltage limiter L23 and a fourth voltage limiter L34, which are all connected in series. Here, the fourth voltage limiter L34 is connected to the full supply voltage and hence to the supply voltage terminal VSPL, e.g. with a high-voltage terminal VHIGH. A low-voltage terminal VLOW of the fourth voltage limiter L34 is connected to a high-voltage terminal VHIGH of the third voltage limiter L23.

Moreover, a low-voltage terminal VLOW of the third voltage limiter L23 is connected to a high-voltage terminal VHIGH of the second voltage limiter L12. The general working principle of the voltage transmitter circuit 10 may require only first and second voltage limiters L01, L12 coupled to first and second switch stages S01, S12 in combination with an at least first tank capacitor C1. A voltage transmitter circuit 10 as illustrated in the block diagram of Fig. 2 comprising numerous supplemental device capacitors C2, C3 and an optional capacitor C4 in combination with further voltage limiters L23, L34 and switch stages S23, S34 may provide better and improved performance.

The topology is based on using a series connection, or a stack, of multiple voltage limiters, L01, L12, L23, L34, in combination with a series connection, or a stack, of switch stages S01, S12, S23, S34, and a set of grounded tank capacitors, C1, C2, C3. The full supply voltage VSPL or V4 is supposed to be constant, that is, driven by a strong or low impedance voltage source VMAIN. Optionally, a supplemental tank capacitor C4 can be connected between the full supply VSPL or V4 and ground VGND or V0 in order to minimize a voltage ripple at the full supply. During the operation of the circuit 10, voltages V1, V2, V3 are supposed to be spaced between the ground rail VGND having zero voltage and the full supply rail VSPL having the full supply voltage.

The spacing is designed to be approximately uniform, that is, the voltage differences across all limiters L01, L12, L23, L34 are designed to be approximately equal. For clarity, the ground rail VGND is also denoted as V0 and the full supply voltage VSPL is also denoted as V4 for the numeric index to indicate the growing voltage level with respect to ground. Also, the voltage limiters are denoted as L01, L12, L23, L34 and the switch stages are denoted as S01, S12, S23, S34 for the combination of numeric indices to indicate the two voltage levels between which the respective block is designed to operate.

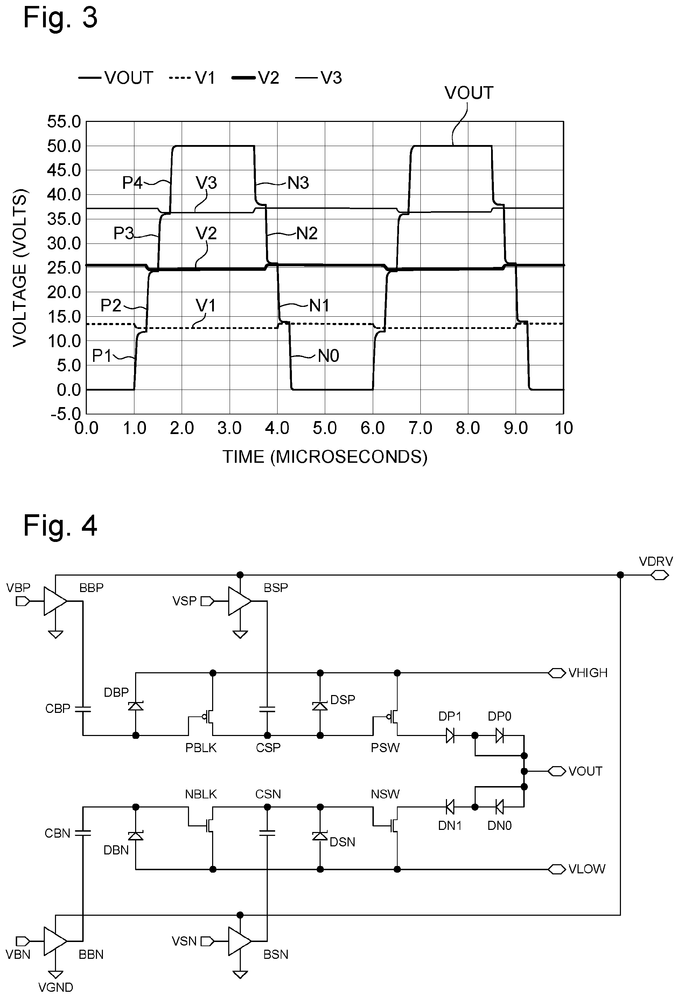

Each intermediate voltage net V1, V2, V3 is directly connected to the respective two switch stages, S01 and S12, S12 and S23, S23 and S34. These connections are designed to carry the dominant transient currents or charge transfers during the operation of the circuit. As will be explained in greater detail in connection with Fig. 4, the individual switch stages S01, S12, S23 and S34 each comprise a switch of a first type P1, P2, P3, P4 and a switch of a second type N0, N1, N2, N3.

As indicated in Fig. 2, the first switch stage S01 comprises a first high-voltage terminal VHIGH01 and a first low-voltage terminal VLOW01. The second switch stage S12 comprises a second high-voltage terminal VHIGH12 and a second low-voltage terminal VLOW12. The third switch stage S23 comprises a third high-voltage terminal VHIGH23 and a third low-voltage terminal VLOW23 and the fourth switch stage S34 comprises a fourth high-voltage terminal VHIGH34 and a fourth low-voltage terminal VLOW34.

The switch stages S01, S12, S23, S34 are connected in series. Accordingly, the first high-voltage terminal VHIGH01 is connected to the second low-voltage terminal VLOW12. Accordingly, the second high-voltage terminal VHIGH12 is connected to the third low-voltage terminal VLOW23 and the third high-voltage terminal VHIGH23 is connected to the fourth low-voltage terminal VLOW34. The first low-voltage terminal VLOW01 is connected to ground and the fourth high-voltage terminal VHIGH34 is connected to the supply voltage terminal VSPL.

Below and as far as not described to the contrary any reference to a high-voltage terminal VHIGH or low-voltage terminal VLOW applies to any of the voltage terminals VHIGH01, VHIGH12, VHIGH23 or VHIGH34 or VLOW01, VLOW12, VLOW23, VLOW34 of the individual switch stages S01, S12, S23, S34.

Specifically, as the load capacitance CLOAD is charged or discharged, the related charge or discharge current loop goes via the load capacitance CLOAD, one of the switches N0, N1, N2, N3, P1, P2, P3, P4 and the respective tank capacitor, that is, C1 in the case of N1 or P1, C2 in the case of N2 or P2, C3 in the case of N3 or P3 or the ground rail V0 in the case of N0 or the supply rail V4 with the optional tank capacitor C4 in the case of P4.

In addition, the voltage transmitter circuit 10 comprises a bias network that is primarily designed to define the operating voltages at the tank capacitors C1, C2, C3 but is not supposed to carry significant currents. The bias network includes the limiters L01, L12, L23, L34 and bias resistors R1, R2, R3. The bias resistors R1, R2, R3 are connected in series between the voltage node VB1, VB2, VB3 between the stack of voltage limiters L01, L12, L23, L34 and the associated tank capacitors C1, C2, C3. Hence, the bias resistor R1 is located between the first tank capacitor C1 and the voltage node VB1, the bias resistor R2 is located between the second tank capacitor C2 and the voltage node VB2, and the bias resistor R3 is located between the third tank capacitor C3 and the voltage node VB3.

The limiters L01, L12, L23, L34 are stacked, that is, they form a series string from the full supply V4 or VSPL via nets VB3, VB2, VB1 to the ground net V0 or VGND. The static current along the said path is designed to be much smaller than the charge or discharge currents flowing between the load capacitance CLOAD and the tank capacitors C1, C2, C3 or the full supply terminal V4 or the ground terminal V0 during the operation of the voltage transmitter circuit 10.

Also, the bias network comprises a set of comparatively large bias resistors R1, R2, R3 where each resistor provides a high resistance connection between a net in the limiter string and a respective tank capacitor, that is, R1 connects VB1 and V1, R3 connects VB2 and V2 and R3 connects VB3 and V3. The static currents via the said bias resistors R1, R2, R3 are designed to be much smaller than the charge or discharge currents flowing between the load capacitance CLOAD and the bias or tank capacitors C1, C2, C3 or the full supply terminal V4 or the ground terminal V0 during the operation of the circuit.

The bias network provides two basic functionalities: On powering up the circuit 10, that is, after the full supply voltage VSPL ramps up from zero to its target value but before any of the switches N0, N1, N2, N3, P1, P2, P3, P4 is closed or made conductive, the bias network slowly charges up all tank capacitors C1, C2, C3 up to their respective target voltages V1, V2, V3 that are approximately uniformly spaced between the full supply voltage VSPL or V4 and the ground VGND or V0.

During the operation of the circuit, as the switches N0, N1, N2, N3, P1, P2, P3, P4 are used to transfer charge between the tank capacitors C1, C2, C3 or the full supply terminal V4 or the ground terminal V0 and the load capacitance CLOAD, the bias network ensures that a long term average value of each of the tank voltages V1, V2, V3 does not significantly depart from the respective voltage VB1, VB2, VB3. However, for good power efficiency of the voltage transmitter circuit 10, the resistances of the bias resistors R1, R2, R3 have to be large, in order that the total power or energy dissipated in all the resistors within any complete signal period or cycle including full charging and full discharging of the capacitive load CLOAD forms a negligible part of the total power or energy dissipated in the full system.

Here, it is of particular benefit that the charge or discharge process during a signal period uses only switches and grounded capacitive elements C1, C2, C3, that is, the transient current loop goes via the capacitors C1, C2, C3 and the optional capacitor C4 almost exclusively, with virtually no share or contribution from the bias resistors R1, R2, R3 or other parts of the bias network.

Another principal feature of the proposed topology is that parasitic capacitances present at either terminal or plate of the tank capacitors C1, C2, C3 or the optional capacitor C4 cause no degradation to circuit performance as these parasitic elements are either shorted or placed in parallel with the useful capacitance of the respective tank capacitor. It may be provided that the capacitances of the capacitors C1, C2, C3 as well as the optional capacitor C4 are typically designed to be much larger than the expected capacitive load CLOAD. Therefore, the parasitic capacitances associated with the tank capacitors C1, C2, C3 can also become relatively large but, as noted above, in this topology they bring no degradation.

On powering up the circuit, the bias network charges the tank capacitors in such a way that the tank voltages are spaced approximately uniformly, that is, all differences V1-V0, V2-V1, V3-V2 and V4-V3 are approximately equal. The switches N0, N1, N2, N3, P1, P2, P3, P4 operate in such a way that, at any given time, only one switch is closed or conductive while all other switches are open or nonconductive. Furthermore, the switch configuration is always changed in a nonoverlapping way, that is, the closed or conductive switch is first open or made nonconductive before any other switch is closed or made conductive. In the paragraphs below, only the closed or conductive switch device will be named as it is understood that all other switch devices are open or nonconductive at the same time.

If the starting point is a fully discharged capacitive load CLOAD, that is, if the output voltage VOUT equals the ground voltage VGND or V0, then the switches P1, P2, P3, P4 are closed or made conductive in the given sequence, in order to connect the output VOUT to the tank voltages V1, V2, V3 and the full supply voltage V4 in the respective order, in order to make a full transition from the ground voltage up to the full supply voltage.

Accordingly, the switch P1 will be closed, thereby connecting the first tank capacitor C1 to the output voltage terminal VOUT. Accordingly, the capacitive load CLOAD will be charged by the first tank capacitor C1. Then, the switch P1 will be opened or made nonconductive before switch P2 is closed thereby connecting the second tank capacitor C2 to the output voltage terminal VOUT. Accordingly, the capacitive load CLOAD will be further charged by the second tank capacitor C2. Then, the switch P2 will be opened or made nonconductive before switch P3 is closed thereby connecting the third tank capacitor C3 to the output voltage terminal VOUT. Accordingly, the capacitive load CLOAD will be further charged by the third tank capacitor C3. Then, the switch P3 will be opened or made nonconductive before switch P4 is closed thereby connecting the full supply voltage VSPL to the capacitive load CLOAD. Finally, the switch P4 may remain closed or conductive to keep the output terminal VOUT at the full supply voltage V4.

If the starting point is a fully charged capacitive load CLOAD, that is, if the output voltage VOUT equals the full supply voltage VSPL or V4, then the switches N3, N2, N1, N0 are closed or made conductive in the given sequence, in order to connect the output VOUT to the voltages V3, V2, V1 and the ground voltage V0 in the respective order, in order to make a full transition from the full supply voltage down to the ground voltage. Finally, the switch N0 may remain closed or conductive to keep the output terminal VOUT at the ground voltage V0. The timing of the switches N3, N2, N1 and N0 is similar to switches P1, P2, P3, P4, respectively.

During square wave signalling, the rising and falling transitions are always interleaved, that is, the output voltage must first make a rising transition from the ground voltage up to the full supply voltage before it can make a falling transition from the full supply voltage down to the ground voltage. During a rising transition, as the load capacitance CLOAD is sequentially connected via switches P1, P2, P3 to the capacitors C1, C2, C3, charge is transferred from these capacitors C1, C2, C3, one at a time, to the load capacitance. Conversely, during a falling transition, as the capacitive load CLOAD is sequentially connected via switches N3, N2, N1 to the capacitors C3, C2, C1, charge is transferred from the load capacitance to these capacitors, one at a time.

As stated above, the spacing of the voltages V1, V2, V3 is approximately equal. Furthermore, the capacitive load CLOAD typically has a flat voltage dependence. Consequently, the amount of charge taken from each capacitor C1, C2, C3 during a rising transition is approximately equal to the amount of charge returned to the same capacitor C1, C2, C3 during a falling transition. As the rising and falling transitions are interleaved, the system can operate in a periodic steady state where virtually no static current needs to be supplied to the capacitors C1, C2, C3 by the bias network. It is also of benefit that the circuit 10 is designed to maximise the amount of charge that is conserved or exchanged between the capacitive load CLOAD on one hand and the capacitors C1, C2 and C3 on the other hand.

Charge is only lost when the output VOUT is connected via switch N0 to the ground voltage VGND. Recharge from the supply is only needed when the output VOUT is connected via switch P4 to the full supply VSPL. Contrast to a classic inverter which charges the load capacitance to the full supply and then completely discharges the load capacitance to the ground, the presented topology needs N times less charge where N equals the number of stacked stages (four in the example presented in Fig. 2). The same factor of improvement applies to power or energy consumed by the system. Small negative steps on the voltages V1, V2, V3 can be observed as the output makes a rising transition and charge is taken from the tank capacitors. However, this is compensated by small positive steps on the respective voltages as the output subsequently makes a falling transition and charge is returned to the tank capacitors as become apparent from the illustration of Fig. 3.

There, operation of the switches P1, P2, P3 and P4 as well as operation of the switches N3, N2, N1 and N0 is indicated together with the voltage level VOUT obtained at the output voltage terminal. Moreover, the individual intermediate voltage levels at the nodes V1, V2, V3 and the small voltage ripples obtained during the switching steps are discernible. Fig. 3 represents an example operation of the circuit 10 as illustrated in Fig. 2 simulated in a 180nm BCD technology.

The embodiment shown in Fig. 2 comprises the switch stages S01, S12, S23, S34 arranged in a series or stack in such a way that the individual paths between their switch terminals VHIGH, VLOW form a series combination in the same way as the respective terminals VHIGH, VLOW of the individual limiters L01, L12, L23, L34. As this is a high voltage system, the internal switches N0, N1, N2, N3, P1, P2, P3, P4 are typically implemented as LD NMOS or LD PMOS transistor devices that can handle large voltage differences between the source terminal and the drain terminal. However, the voltage difference between the gate terminal and source terminal is limited to a relatively small voltage, and, in the majority of available technologies, the limit is not substantially greater than 5V. At the same time, large voltages with respect to ground at terminals VHIGH or VLOW or both may be present, in particular at those limiter stages which are near the full supply end of the series combination or stack.

Fig. 4 shows an example of the switch stage implementation. Here, the LD NMOS transistor device corresponds to the switches N0, N1, N2, N3 of Fig. 2, which is marked as NSW in Fig. 4. The LD PMOS transistor device corresponds to the switches P1, P2, P3, P4 of Fig. 2, which is marked as PSW in Fig. 4.

While a LD NMOS device can handle large positive voltage at its drain with respect to the voltage at its source, it cannot handle a situation where the drain voltage is negative with respect to the source voltage. Therefore, to cover the situation where the voltage at terminal VOUT is below the voltage at terminal VLOW, the circuit includes one or more protection diodes DN0, DN1. In switch S01 of Fig. 2, these diodes may be shorted as indicated in Fig. 4 or completely omitted as voltage VOUT can never get below VGND. Conversely, in switch S34 or other switches near the full supply voltage, a series combination of more than one diode may be needed, that is, the short over DN0 in Fig. 4 may need to be removed.

While a LD PMOS device can handle large negative voltage at its drain with respect to the voltage at its source, it cannot handle a situation where the drain voltage is positive with respect to the source voltage. Therefore, to cover the situation where the voltage at terminal VOUT is above the voltage at terminal VHIGH, the respective switch stage includes one or more protection diodes DP0, DP1. In switch S34 of Fig. 2, these diodes may be shorted as indicated in Fig. 4 or completely omitted as voltage VOUT can never get above VSPL. Conversely, in switch S01 or other switches near the ground voltage, a series combination of more than one diode may be needed, that is, the short over DP0 in Fig. 4 may need to be removed.

A suitable implementation of diodes DN0, DN1, DP0, DP1, as applicable, is the Schottky type of diode that has small forward voltage and virtually no minority carrier injection. However, other implementations of diode devices may also be suitable if forward current via the diode structure is acceptable in the given technology.

The magnitude of the voltage between the gate and source of a LDMOS device is typically limited to a value much smaller than the maximum voltage between the drain and source. In the presently available high voltage technologies, Zener diodes are provided as local voltage limiters to place between the gate terminal and the source terminal and ensure that the voltage between these two terminals cannot get beyond the safe operating area for the LD MOS device. In each technology, the reverse breakdown voltage of the Zener diode is adjusted to match the maximum magnitude of the gate source voltage of the LD MOS device to protect, and both values may be around 5V.

In Fig. 4, a Zener diode DSN is used to protect the LD NMOS transistor NSW and a Zener diode DSP is used to protect the LD PMOS transistor PSW. Said protective elements ensure that the voltage swings of the control signals at the gates of the LD MOS switch devices cannot exceed the safe operating areas of these devices. Specifically, the voltage at the gate of the device NSW remains approximately between VLOW and VLOW+VZ and the voltage at the gate of the device PSW remains approximately between VHIGH and VHIGH-VZ, where VZ is the magnitude of the reverse breakdown voltage of the Zener diodes DSN, DSP.

As follows from Fig. 2, the voltages at terminals VLOW, VHIGH of the individual switch stages S01, S12, S23, S34 range from the ground voltage to the full supply voltage that can be greater than 50V. In contrast, the voltage swings at the gate terminals of switch devices NSW, PSW in the individual switch stages S01, S12, S23, S34 are limited to approximately 5V. In other words, typically, the safe voltage swings at the individual gate terminals are much smaller than the full supply voltage. Typically, control signals for gate terminals of LD MOS devices having source terminals at high voltages with respect to ground are driven by level shifter circuits that output signals of limited voltage swing superimposed on a large static voltage level. In principle, such technique can be used here, but it typically means extra power consumption.

In contrast, the example implementation of the switch stages according to Fig 4 uses standard logic buffers or drivers BSN, BSP operating from a control supply voltage VDRV that provides control signal voltages ranging from the ground voltage VGND to the control supply voltage VDRV that does not exceed 5V or the reverse breakdown voltage of the Zener devices.

The control signals to operate the switch stages S01, S12, S23, S34 may be provided by a digital controller 50 as indicated in Fig. 2. Inside the individual switch stages, those control signals may be level shifted via capacitors CSN, CSP that are used to pass the voltage swing over the static voltage difference. The Zener diodes DSN, DSP ensure that the voltage at the gate of the device NSW is approximately between VLOW and VLOW+VZ and the voltage at the gate of the device PSW is approximately between VHIGH, VHIGH-VZ where VZ is the magnitude of the reverse breakdown voltage of the Zener diodes DSN, DSP.

Such an implementation may be simpler and more power efficient than a standard level shifter. However, the capacitive coupling via capacitors CSN, CSP, may not guarantee that the switch devices NSW, PSW remain fully open or nonconductive when large and fast voltage transitions are present at the output terminal VOUT.

Specifically, when the output voltage VOUT makes a rising transition, the gate source voltage of the LD NMOS switch device NSW may get positive due to the coupling via the gate drain capacitance of said switch device. Conversely, when the output voltage VOUT makes a falling transition, the gate source voltage of the LD PMOS switch device PSW may get negative due to the coupling via the gate drain capacitance of said switch device. Such operating conditions may cause leakage via either switch device and degrade system performance.

To ensure that the LD NMOS switch device NSW can be made fully open or nonconductive and remain in such condition even when the output voltage VOUT makes a fast rising transition, a LD NMOS blocking device NBLK is used that shorts the gate terminal of the switch device NSW to the terminal VLOW and thus guarantees zero value of its gate source voltage. Also, to ensure that the LD PMOS switch device PSW can be made fully open or nonconductive and remain in such condition even when the output voltage VOUT makes a fast falling transition, a LD PMOS blocking device PBLK is used that shorts the gate terminal of the switch device PSW to the terminal VHIGH and thus guarantees zero value of its gate source voltage.

The blocking device NBLK is protected with a Zener diode DBN and controlled with a standard buffer or driver BBN coupled via a coupling capacitor CBN in the same way as NSW is protected with DSN and controlled with BSN coupled via CSN, respectively. Contrast to the switch device NSW, the blocking device NBLK does not have any terminal exposed to large voltage transitions and the capacitive coupling via capacitor CBN is sufficient to provide the appropriate control voltage waveform at the gate of the blocking device NBLK.

Also, the blocking device PBLK is protected with a Zener diode DBP and controlled with a standard buffer or driver BBP coupled via a coupling capacitor CBP in the same way as PSW is protected with DSP and controlled with BSP coupled via CSP, respectively. In contrast to the switch device PSW, the blocking device PBLK does not have any terminal exposed to large voltage transitions and the capacitive coupling via capacitor CBP may be sufficient to provide the appropriate control voltage waveform at the gate of the blocking device PBLK.

In the example implementation shown in Fig. 4, standard buffers or drivers BSN, BBN, BSP, BBP are used to provide the control signals for the gate terminals of LD MOS devices NSW, NBLK, PSW, PBLK, respectively. A buffer or driver stage reproduces the polarity of the digital signal. Therefore, a rising edge at the input signal VSN, VBN, VSP, VBP generates a rising edge at the gate terminal of the LD MOS device NSW, NBLK, PSW, PBLK, respectively. Conversely, a falling edge at the input signal VSN, VBN, VSP, VBP generates a falling edge at the gate terminal of the LD MOS device NSW, NBLK, PSW, PBLK, respectively.

Also, a rising edge at the gate of a LD NMOS switch device makes it closed or conductive while a falling edge makes it open or nonconductive. Conversely, a falling edge at the gate of a LD PMOS switch device makes it closed or conductive while a rising edge makes it open or nonconductive.

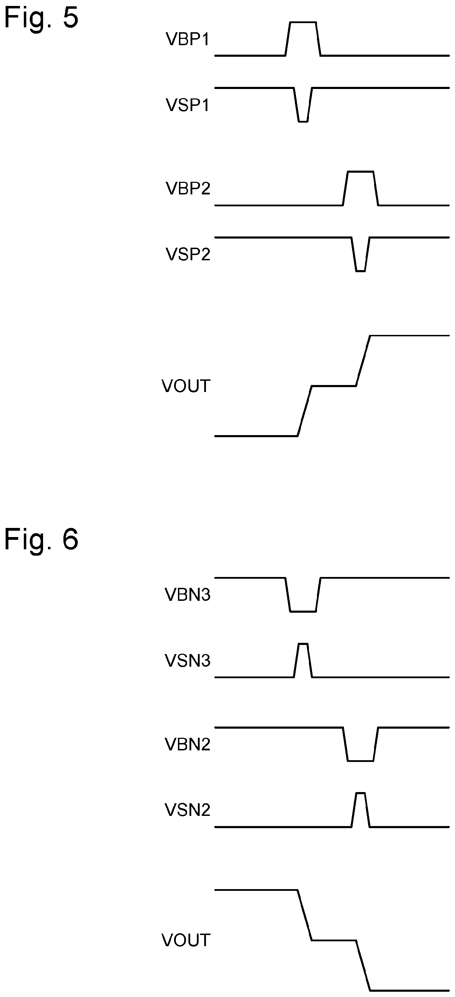

As described above in more detail, for the circuit 10 to generate a complete transition from the ground voltage up to the full supply voltage, the switches P1, P2, P3, P4 have to be closed or made conductive, in the given sequence. Fig. 5 presents typical control waveforms to use for the first steps of such sequence. A positive pulse or signal VBP1 in the switch stage S01 deactivates or opens the blocking device PBLK. Within said pulse, that is, while the blocking device PBLK in the switch stage S01 is open or deactivated, a negative pulse on signal VSP1 closes or activates the switch device PSW in the switch stage S01 for finite time, and during that time, the output voltage VOUT makes a positive step.

The same procedure is repeated for the signals VBP2 and VSP2 controlling the respective blocking device PBLK in the switch stage S12 and the respective switch device PSW in the switch stage S12. Consequently, the output voltage VOUT makes another positive step as shown in Fig. 5. The procedure is continued for the remaining switch stages, that is S23 controlled by signals VBP3, VSP3 and S34 controlled by signals VBP4, VSP4 as outlined in Fig. 2.

In Fig. 5, no overlap between the activity of signals VBP1, VSP1 and the activity of signals VBP2, VSP2 is shown. However, the duration of all pulses can be extended, meaning that, during the generation of a rising transition at the system output, the activities of switch devices PSW in the adjacent switch stages S01, S12 can overlap, that is, the devices PSW in both stages can be both active or closed for some time. Such mode of operation can be used for any two adjacent switch stages and may be suitable if high speed operation is required.

Conversely, for the system to generate a complete transition from the full supply voltage down to the ground voltage, the switches N3, N2, N1, N0 have to be closed or made conductive, in the given sequence. Fig. 6 presents typical control waveforms to use for the first steps of such sequence. A negative pulse or signal VBN3 in the switch stage S34 deactivates or opens the blocking device NBLK. Within said pulse, that is, while the blocking device NBLK in the switch stage S34 is open or deactivated, a positive pulse on signal VSN3 closes or activates the switch device NSW in the switch stage S34 for finite time, and during that time, the output voltage VOUT makes a negative step. The same procedure is repeated for the signals VBN2 and VSN2 controlling the respective blocking device NBLK in the switch stage S23 and the respective switch device NSW in the switch stage S23.

Consequently, the output voltage VOUT makes another negative step as shown in Fig. 6. The procedure is continued for the remaining switch stages, that is S12 controlled by signals VBN1, VSN1 and S01 controlled by signals VBN0, VSN0 as outlined in Fig. 2.

In Fig. 5, no overlap between the activity of signals VBN3, VSN3 and the activity of signals VBN2, VSN2 is shown. However, the duration of all pulses can be extended, meaning that, during the generation of a falling transition at the system output, the activities of switch devices NSW in the adjacent switch stages S34, S23 can overlap, that is, the devices NSW in both stages can be both active or closed for some time. Such mode of operation can be used for any two adjacent switch stages and may be suitable if high speed operation is required.

An initialization method can be used to ensure that the correct operating points are reached in all switch stages S01, S12, S23, S34 including appropriate voltages across capacitors CSN, CBN, CSP, CBP before the first pulse is transmitted. The method consists in applying pulses at all clocking inputs VBN0, VBN1, VBN2, VBN3, VBP1, VBP2, VBP3, VBP4 as presented in Figs. 5 and 6 without any activity at any switch input VSN0, VSN1, VSN2, VSN3, VSP1, VSP2, VSP3, VSP4. On completing this procedure, appropriate voltages at capacitors CBN, CBP are set thanks to the limiting characteristics of Zener diodes DBN, DBP, respectively, and appropriate voltages at capacitors CSN, CSP are set thanks to the switching activity of LD MOS devices NBLK, PBLK, respectively. However, no disturbing signal at the system output VOUT is generated at any time.

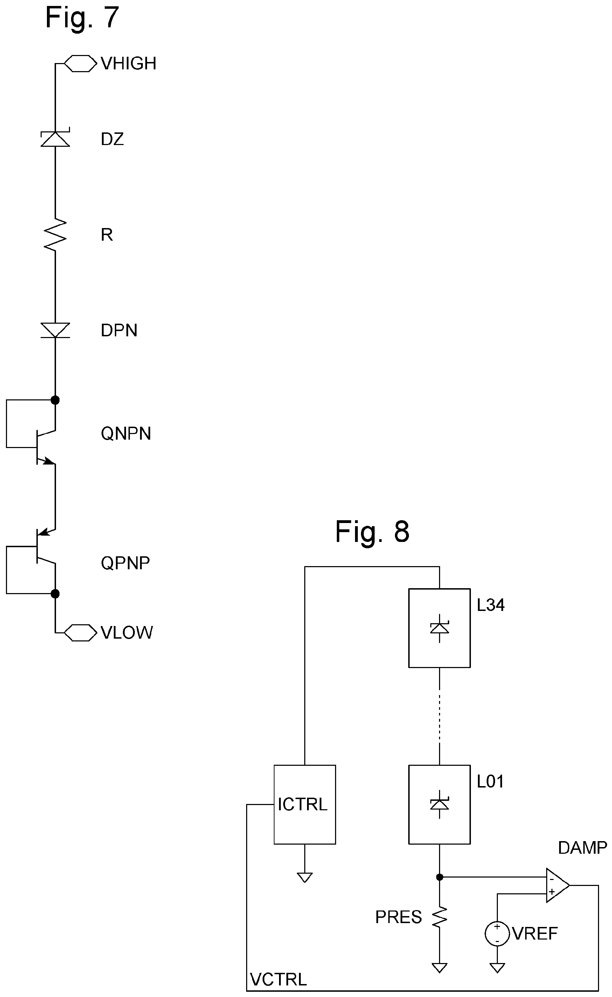

Fig. 7 shows an illustration of various options available for the implementation of the limiter stage used in the system outlined in Fig. 2. As the main target of this invention is low power applications, the limiter should carry very small static current until a threshold voltage is reached. Therefore, a typical implementation uses a reverse biased Zener diode DZ, in series with a linear resistor R or a forward biased PN diode DPN or a diode connected NPN bipolar device QNPN or a diode connected PNP bipolar device QPNP. The series combination may include more series units of each type. The most practical combination is one or more Zener diodes in series with zero or more linear resistors.

As can be seen from Fig. 2, in the proposed topology, a series combination of voltage limiters L01, L12, L23, L34 is connected between the supply voltage VSPL and ground VGND. As the main target of this invention is low power applications, the static current via the series connection or stack of these limiters has to be minimized. Ideally, each of the limiters should be maintained as a point near its voltage threshold where the static current is still very small.

A suitable technique is presented in Fig. 8. Here, the power supply providing the full supply voltage is controlled in such a way that a predefined amount of static current via the limiter stack is reached. The example implementation uses a small probe resistor PRES that generates a voltage proportional to the current flowing through it. Such voltage is next compared to a reference voltage VREF by means of a differential amplifier DAMP that outputs a control voltage VCTRL proportional to its input voltage difference. Said control voltage VCTRL is then used to steer the power supply via its control input ICTRL.

The feedback mechanism is negative, that is, small current via the limiter stack results in small voltage across the probe resistor PRES, which in turn results in large or positive difference voltage and large control voltage that steers the power supply to increase the full supply voltage, and conversely, large current via the limiter stack results in large voltage across the probe resistor, which in turn results in small or negative difference voltage and small control voltage that steers the power supply to decrease the full supply voltage. In some systems, a requirement on the power supply block to have a control input means no practical limitation as power supply circuits for the high voltage transmitters are typically implemented as DCDC converters or include linear regulators where, in both cases, a control element is already present.

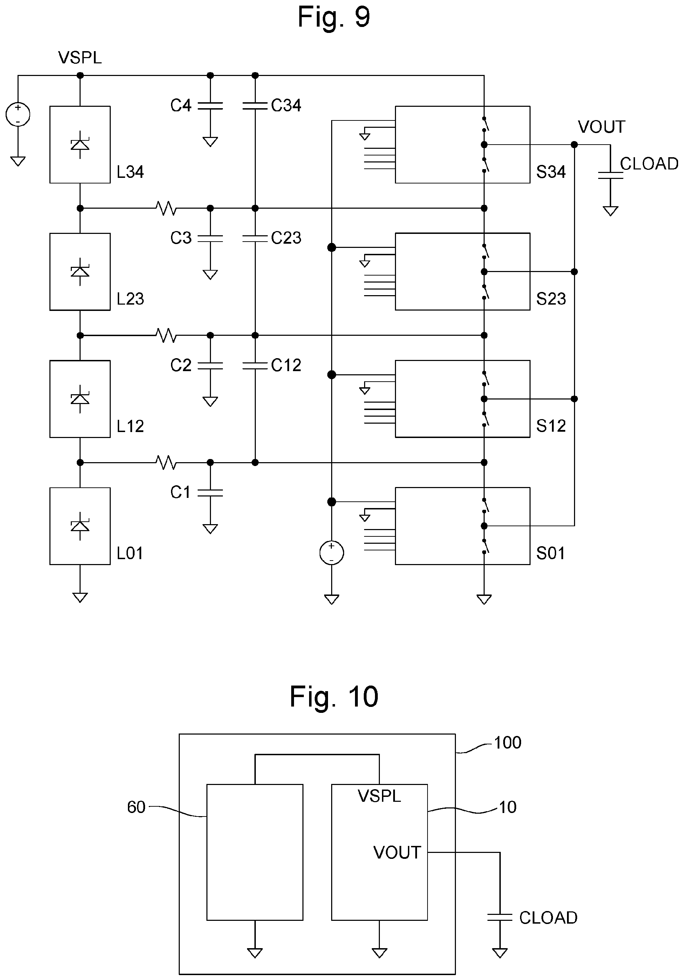

Fig. 9 illustrates an informative example to the implementation of the voltage transmitter circuit 10, which is highly similar to the example shown in Fig. 2 but here, a series combination of tank capacitors C1, C12, C23, C34 is used instead of grounded capacitors C1, C2, C3 as described in connection with Fig. 2. Optionally, there may be provided supplemental ground connected capacitors C1, C2, C3. Hence, the alternative example according to Fig. 9 may comprise only the tank capacitors C1, C12, C23, C34 without the optional capacitors C2, C3, C4.

Here, the second tank capacitor C12 is connected in parallel with the second voltage limiter L12 and with the second switch stage S12. Likewise, the third tank capacitor C23 is connected in parallel with the third voltage limiter L23 and with the third switch stage S23. Additionally, the fourth tank capacitor C34 is connected in parallel with the fourth voltage limiter L34 and with the fourth switch stage S34.

Implementing only C1, C12, C23, C34 brings the advantage of reduced voltage across each of these capacitors, allowing the use of capacitor types with thin dielectric and greater area efficiency.

The block diagram of Fig. 10 illustrates an example of an electronic device 100, e.g. implemented as a mobile electronic device, which comprises an electrical power source, e.g. in form of a battery 60 and a voltage transmitter circuit 10 as described above. The voltage transmitter circuit 10 is connected or coupled to a capacitive load CLOAD. The voltage transmitter circuit 10 is particularly configured for charging and discharging the capacitive load as described above. Insofar, all features, effects and benefits as described above in connection with the voltage transmitter circuit 10 may equally apply to the electronic device 100.

## Claims

1. A voltage transmitter circuit (10) comprising:
- a supply voltage terminal (VSPL),
- an output voltage terminal (VOUT) connectable to a capacitive load (CLOAD),
- a first voltage limiter (L01) comprising a high-voltage terminal (VHIGH) and a low voltage terminal (VLOW), wherein the low voltage terminal (VLOW) is connected to ground,
- a second voltage limiter (L12) in series to the first voltage limiter (L01) and connected to the supply voltage terminal (VSPL),
- a first switch stage (S01) connected in parallel to the first voltage limiter (L01), and comprising a first output terminal (VOUT01) connected to the output voltage terminal (VOUT),
- a second switch stage (S12) connected in parallel to the second voltage limiter (L12), and comprising a second output terminal (VOUT12) connected to the output voltage terminal (VOUT), and
- a first tank capacitor (C1) connected to the high-voltage terminal (VHIGH) of the first voltage limiter (L01).

2. The voltage transmitter circuit (10) according to claim 1, wherein a first terminal of the first tank capacitor (C1) is connected to the high-voltage terminal (VHIGH) of the first voltage limiter (L01) and wherein a second terminal of the first tank capacitor (C1) is connected to ground.

3. The voltage transmitter circuit (10) according to any one of the preceding claims, wherein the first switch stage (S01) comprises a first high-voltage terminal (VHIGH01) and a first low-voltage terminal (VLOW01), wherein the first low-voltage terminal (VLOW01) is connected to ground.

4. The voltage transmitter circuit (10) according to claim 3, wherein the second switch stage (S12) comprises a second high-voltage terminal (VHIGH12) and a second low-voltage terminal (VLOW12), wherein the second low-voltage terminal (VLOW12) is connected to the first high-voltage terminal (VHIGH01) of the first switch stage (S01).

5. The voltage transmitter circuit (10) according to claims 3 and 4, wherein the first switch stage (S01) and the second switch stage (S12) each comprise a switch of a first type (P1, P2) and a switch of a second type (N0, N1), wherein the switch of the first type (P1, P2) is operable to connect the high-voltage terminal (VHIGH01, VHIGH12) of the first or second switch stages (S01, S12) with the respective output terminal (VOUT01, VOUT12) of the first or second switch stages (S01, S12) and wherein the switch of the second type (N0, N1) is operable to connect the low-voltage terminal (VLOW01, VLOW12) of the first switch stage (S01) or of the second switch stage (S12) with the respective output terminal (VOUT01, VOUT12) of the first or second switch stages (S01, S12).

6. The voltage transmitter circuit (10) according to any one of the preceding claims 3 to 5, wherein at least one of the first high-voltage terminal (VHIGH01) and the second low-voltage terminal (VLOW12) is connected to the first tank capacitor (C1).

7. The voltage transmitter circuit (10) according to any one of the preceding claims, further comprising:
- a third voltage limiter (L23) in series to the second voltage limiter (L12),
- a third switch stage (S23) connected in parallel to the third voltage limiter (L23), and comprising a third output terminal (VOUT23) connected to the output voltage terminal (VOUT), and
- a second tank capacitor (C2, C12) connected to a high-voltage terminal (VHIGH12) of the second voltage limiter (L12).

8. The voltage transmitter circuit (10) according to claim 7, wherein the third switch stage (S23) comprises a third high-voltage terminal (VHIGH23) and a third low-voltage terminal (VLOW23), wherein the third low-voltage terminal (VLOW23) is connected to the second high-voltage terminal (VHIGH12) of the second switch stage (S12) and wherein one of the second high-voltage terminal (VHIGH12) and the third low-voltage terminal (VLOW23) is connected to the second tank capacitor (C2).

9. The voltage transmitter circuit (10) according to claim 7 or 8, wherein the second tank capacitor (C12) comprises a first terminal connected to the second high-voltage terminal (VHIGH12) and a second terminal connected to one of the first high-voltage terminal (VHIGH01) and the second low-voltage terminal (VLOW12).

10. The voltage transmitter circuit (10) according to any one of the preceding claims further comprising a digital controller (50), which is operable to control switching operations of the first and the second switch stages (S01, S12) in a non-overlapping sequential order.

11. The voltage transmitter circuit (10) according to claim 5, wherein the switch of the first type (P1, P2) comprises a LD PMOS transistor (PSW) connected to the high-voltage terminal (VHIGH01, VHIGH12) and connected to the output terminal (VOUT01, VOUT12) of the first or second switch stages (S01, S12).

12. The voltage transmitter circuit (10) according to claim 5 or 11, wherein the switch of the second type (N0, N1) comprises a LD NMOS transistor (NSW) connected to the low-voltage terminal (VLOW01, VLOW12) and connected to the output terminal (VOUT01, VOUT12) of the first or second switch stages (S01, S12).

13. The voltage transmitter circuit (10) according to claim 11 or 12, further comprising at least one of a blocking switch (PBLK) of a first type and a blocking switch (NBLK) of a second type, wherein the blocking switch (PBLK) of the first type is coupled to the LD PMOS transistor (PSW) and wherein the blocking switch (NBLK) of the second type is coupled to the LD NMOS transistor (NSW), wherein the blocking switch (PBLK) of the first type is operable to connect a gate of the LD PMOS transistor (PSW) to the high-voltage terminal (VHIGH01, VHIGH12) and wherein the blocking switch (NBLK) of the second type is operable to connect a gate of the LD NMOS transistor (NSW) to the low-voltage terminal (VLOW01, VLOW12).

14. An electronic device (100) comprising:
- a battery (60), and
- a voltage transmitter circuit (10) according to any one of the preceding claims, wherein the supply voltage terminal (VSPL) of the voltage transmitter circuit (10) is connectable to the battery (60) the voltage of the battery is converted into a predetermined voltage at the output voltage terminal (VOUT) of the voltage transmitter circuit (10).

15. A method of converting a supply voltage provided at a supply voltage terminal (VSPL) of a voltage transmitter circuit (10) according to any one the preceding claims into an output voltage at the output voltage terminal (VOUT), comprising the steps of:
- sequentially operating first and second switch stages (S01, S12) of the voltage transmitter circuit (10) thereby
- charging and/or discharging the capacitive load (CLOAD), and
- providing a predetermined voltage at the output voltage terminal (VOUT).
